# EUROPEAN PATENT SPECIFICATION

(11) **EP 1 727 284 B1**
(45) Date of publication and mention of the grant of the patent: **06.07.2011**
(21) Application number: 06114557.9
(22) Date of filing: 25.05.2006
(51) Int. Cl.: H03J 1/00

(54) **Electronic apparatus**
Elektronisches Gerät
Appareil électronique

(30) Priority: 27.05.2005 KR 2005045175
(43) Date of publication of application: 29.11.2006
(73) Proprietor: Samsung Electronics Co., Ltd, Suwon-si, Gyeonggi-do 442-742 (KR)
(72) Inventor: Kim, Joon-hwan, Seoul (KR)
(74) Representative: Walaski, Jan Filip

(56) References cited:
- EP-A- 1 467 371
- US-A- 4 207 529
- US-A- 4 476 580
- US-A1- 2004 013 407

## Description

The present invention relates to an electronic apparatus and a control method thereof, and more particularly, to an electronic apparatus having a consecutive search function and a control method thereof.

Generally, an electronic apparatus refers to consumer electronics products such as TVs, electric kitchen appliances, mobile phones, AV products, etc.

As the electronic apparatus comprises much search information, it is required to search information quickly and easily.

For example, if the electronic apparatus is provided as a TV, the search information may be broadcast channels. If the broadcast channel which is currently being displayed is channel No. 2 and a user wants to view the channel No. 55, then a user should press an up/down button 53 times to view the desired channel, or selects a consecutive search function that searches information consecutively until a user stops it.

If searching names from a mobile phone in an alphabetical order, a user may find names by selecting the consecutive search function through a user selection part. However, if searching for "Samsung Electronics" from the mobile phone, it is required to stop the consecutive search function in a name order close to the "Samsung Electronics" and find it.

EP 1467371 discloses a search method for a recording medium having video data stored thereon, wherein the video data can be searched and displayed at different speeds.

Accordingly, it is an aspect of the present invention to provide an electronic apparatus which searches search information quickly and easily by using a consecutive search function.

Additional aspects of the present invention will be set forth in part in the description which follows and, in part, will be obvious from the description, or may be learned by practice of the present invention.

The present invention provides an electronic apparatus comprising:
means (40) for storing a plurality of search items;
a display (30);
a controller (50) configured to search the search items consecutively, to display the search items consecutively on the display (30), and to control a search speed, being a speed at which the search items are displayed during a search session, wherein the controller (50) is arranged to vary the search speed between a relatively high speed and a relatively low speed at which a user can determine the progress of the search; characterised in that the controller (50) is configured to vary the search speed periodically between the relatively high speed and the relatively low speed.

According to an aspect of the present invention, the display part displays a list of the search information, and displays the selected search information to be distinguished from other search information.

According to another aspect of the present invention, the electronic apparatus further comprises an interface generator to generate an interface picture which is displayed on the display part, and the interface picture comprises a speed adjusting menu to adjust at least one of the fastest search speed, the slowest search speed and search speed increase/decrease rate.

According to another aspect of the present invention, the electronic apparatus further comprises an interface generator to generate the interface picture which is displayed on the display part, and the interface picture comprises a period adjusting menu to adjust increase/decrease periods of the search speed.

According to another aspect of the present invention, the display part displays the searched search information only.

According to another aspect of the present invention, the electronic apparatus further comprises a tuner to select a broadcast channel, and the searched search information comprises an image corresponding to the broadcast channel and the controller controls the tuner to display the image corresponding to the searched broadcast channel on the display part if the consecutive search function is selected.

According to another aspect of the present invention, the electronic apparatus further comprises an interface generator to generate the interface picture which is displayed on the display part, and the interface picture comprises a period adjusting menu to adjust increase/decrease periods of the search speed.

According to another aspect of the present invention, the search speed is increased and decreased on the basis of a preset reference speed which is recognizable.

The present invention also provides a control method of an electronic apparatus having a plurality of search information, comprising receiving a selection signal of a consecutive search function; increasing and decreasing a search speed with respect to the search information between a relatively high speed and a relatively low speed at which a user can determine the progress of the search if the selection signal of the consecutive search function is received; and displaying a selected search information; characterised in that the increasing and decreasing of the search speed is carried out periodically.

According to another aspect of the present invention, the displaying of the selected search information comprises displaying a list of the search information, and displaying the searched search information to be distinguished from other search information.

According to another aspect of the present invention, the control method further comprises displaying a speed adjusting menu to adjust at least one of the fastest search speed, the slowest search speed and search speed increase/decrease rate of the search speed.

According to an aspect of the present invention, the control method further comprises displaying a period adjusting menu to adjust a search period of the search speed.

According to another aspect of the present invention, the displaying the searched search information comprises displaying the searched search information only.

According to another aspect of the present invention, the searched search information comprises an image corresponding to a TV channel.

According to another aspect of the present invention, the control method further comprises displaying a period adjusting menu to adjust a search period of the search speed.

The above and/or other aspects of the present invention will become apparent and more readily appreciated from the following description of exemplary embodiments, taken in conjunction with the accompanying drawings of which:
Figure 1 is a control block diagram of an electronic apparatus according to an embodiment of the present invention;
Figure 2 illustrates a search speed of the electronic apparatus according to another embodiment of the present invention;
Figure 3 illustrates menus to adjust a consecutive search function which is displayed on a display part of the electronic apparatus according to another embodiment of the present invention; and
Figure 4 is a control flow chart of the electronic apparatus according to another embodiment of the present invention.

Reference will now be made in detail to exemplary embodiments of the present invention, examples of which are illustrated in the accompanying drawings, wherein like reference numerals refer to like elements throughout.

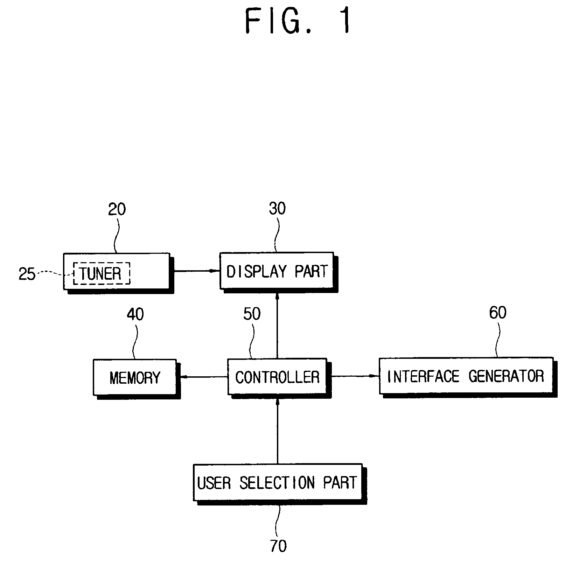

As shown in Figure 1, an electronic apparatus according an exemplary embodiment of the present invention comprises a display part 30 to display a picture thereon, a user selection part 70 and a controller 50 to control the foregoing elements. The electronic apparatus according to another embodiment of the present invention may further comprise a signal processor 20; an interface generator 60 to generate an interface picture which is displayed on the display part 30; and a memory 40 to store predetermined information.

The display part 30 according to the present invention receives a signal which is processed by the signal processor 20 to display the picture thereon. The display part 30 comprises a display module (not shown) to display the picture, and a module driver (not shown) to process the signal input from the signal processor 20 and display the picture on the display module. Here, a cathode ray tube (CRT), a digital light processing (DLP), a liquid crystal display (LCD), or a plasma display panel (PDP) may be provided as the display module according to the present invention.

If the DLP is provided as the display module, the module driver may comprise an optical engine. If the LCD is provided as the display module, the module driver may comprise a printed circuit board (PCB) which converts the signal input from the signal processor 20 into a data signal and a gate signal. Also, the display part 30 may comprise a module driver corresponding to the type of the display module.

The signal processor 20 may comprise various configurations. For example, the signal processor 20 may comprise at least one of a scaler to scale a picture signal and convert it into a vertical frequency, resolution, picture ratio, etc. which conform to output standards of the display part 30; a transition minimized differential signaling (TMDS) receiver to convert the input picture signal into digital R, G and B signals to be processed by the scaler, corresponding to the format of the input picture signal; an A/D converter; a video decoder; and a tuner 25.

The memory 40 is stored with a plurality of search information. Here, the search information comprises broadcast channels and/or broadcast channel information, PC files, radio channels and/or radio channel information, menus and/or name search in mobile phones, etc., but is not limited thereto.

The interface generator 60 generates the interface picture and displays it on the display part 30.

The user selection part 70 is provided to input or select a predetermined function by a user. The user selection part 70 may be provided in various ways such as a plurality of input keys or buttons, a remote control, a keyboard, a mouse, etc. For example, if a user consecutively presses up and down keys of the keyboard or the remote control or an additional consecutive search function key, the consecutive search function, which consecutively searches for next search information until a user stops it, may be selected. In another exemplary embodiment of the present invention, the consecutive search function is stopped if a user stops pressing the up and down keys of the keyboard or the remote control, presses an additional stop button, or presses the consecutive search function again.

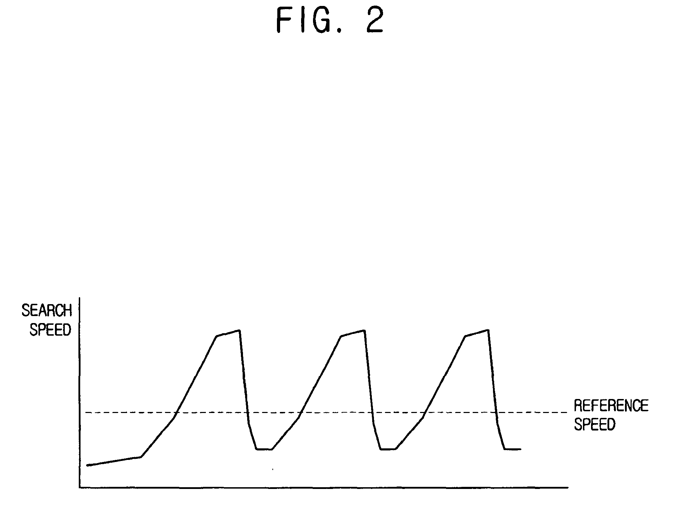

If the consecutive search function is selected through the user selection part 70, the controller 50 increases and decreases a search speed with respect to the search information. That is, the controller 50 increases and decreases the search speed compared to a predetermined reference speed if the consecutive search function is selected. As shown in Figure 2, the search information is searched at a faster search speed than the predetermined reference speed, and then at a slower search speed than the reference speedafter predetermined periods of time. In another exemplary embodiment, the search speed may periodically become faster and then slower again than the reference speed. In another exemplary embodiment of the present invention, the reference speed is a limit speed at which a user recognizes what is searched as the search information. As shown in Fig. 2, in an exemplary embodiment, the search speed and search increase/decrease rate are identical by each period. However the search speed need not necessarily be identical across periods. As long as the search speed becomes faster than the predetermined reference speed periodically, there is no limit to the range of the search speed and to the search increase/decrease rate.

According to an exemplary embodiment of the present invention, if the search information is displayed as a list on the display part 30, the searched search information may be distinguished from other search information. For example, if the memory 40 is stored with a plurality of files and the consecutive search function is operated to search for a user file, the controller 50 controls the display part 30 to display a file list stored in the memory 40 thereon and distinguishes the searched files from other file lists.

If the search information is not displayed as a list on the display part 30, single searched search information may be displayed thereon. A TV will be described as an example of the electronic apparatus according to an exemplary embodiment of the present invention.

If the TV is provided as the electronic apparatus according to an exemplary embodiment of the present invention, the signal processor 20 provided in the TV comprises a tuner 25 to select the broadcast channels. The tuner 25 processes the picture signal received through the selected broadcast channel among broadcast signals received from an antenna (not shown), to be displayed on the display part 30.

If the consecutive search function of the broadcast channel is selected through the user selection part 70, the controller 50 controls the tuner 25 to display the picture corresponding to the searched broadcast channel on the display part 30. Specifically, if the memory 40 stores information about the broadcast channel which is consecutively displayed on the display part 30 according to the consecutive search function, the controller 50 controls the tuner 25 to search the broadcast channel according to the order stored in the memory 40, and displays the picture corresponding to the searched broadcast channel on the display part 30.

Meanwhile, the controller 50 may control the interface generator 60 to display the interface picture comprising the menu for adjusting the consecutive search function, on the display part 30.

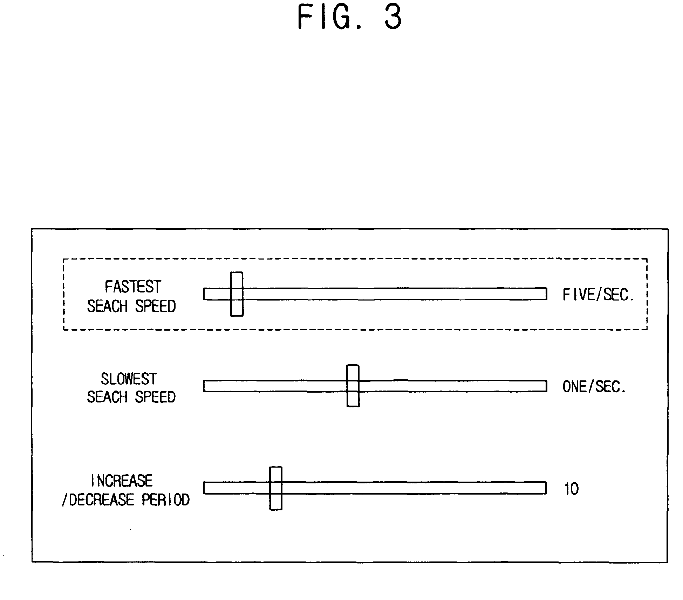

As shown in Figure 3, the menu for adjusting the consecutive search function may comprise at least one of a speed adjusting menu comprising a fastest search speed, a slowest search speed, search speed increase/decrease rate (not shown), etc. and/or a period adjusting menu to adjust increase/decrease periods.

Referring to Figure 3, if the interface picture is displayed on the display part 30 to adjust the fastest search speed, the fastest search speed may be adjusted through the user selection part 70. If the interface picture is displayed on the display part 30 to adjust the slowest search speed, the slowest search speed may be adjusted through the user selection part 70. In the present exemplary embodiment, the fastest search speed is faster than the preset reference speed and the slowest search speed is slower than the preset reference speed. However, these relative speed relationships are not necessary, and alternate embodiments exist.

If the interface picture is displayed on the display part 30 to adjust the increase/decrease period of the search speed, the increase/decrease period may be adjusted through the user selection part 70.

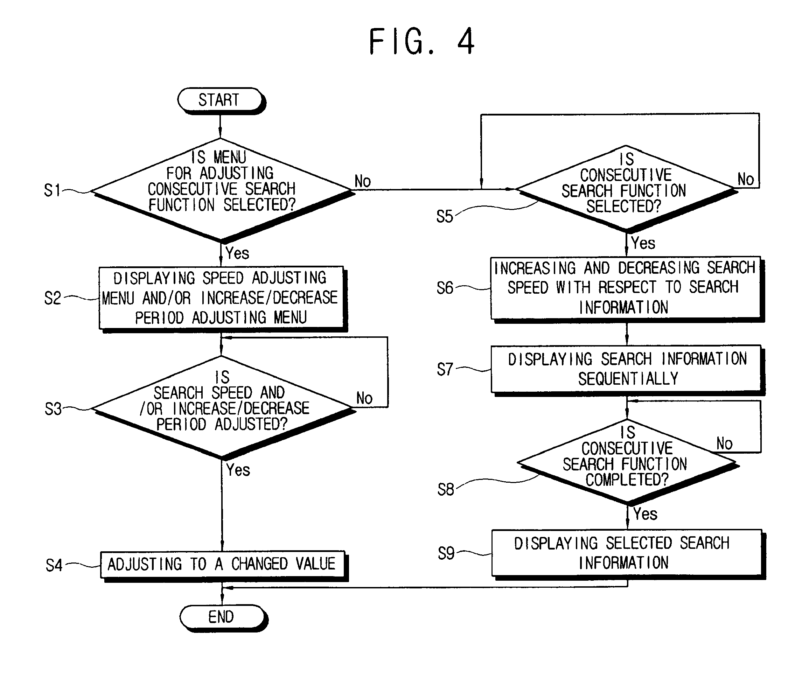

As shown in Figure 4, the electronic apparatus according to the present invention may adjust the search speed and period through the menu for adjusting the consecutive search function. If the menu for adjusting the consecutive search function is selected through the user selection part 70 at operation S1, the controller function is selected through the user selection part 70 at operation S1, the controller 50 controls the interface generator 60 to display the interface picture comprising the speed adjusting menu having at least one of the fastest search speed, the slowest search speed, the search speed increase/decrease rate and the increase/decrease period of the search speed, and/or the menu for adjusting the increase/decrease period at operation S2. If a user adjusts the search speed and/or the increase/decrease period through the menu displayed on the interface picture at operation S3, the controller 50 searches the search information with the adjusted value at operation S4 if the consecutive search function is selected.

If the consecutive search function is selected through the user selection part 70 at operation S5, the search for the search information is started. At this time, the search speed is increased and decreased on the basis of the preset reference speed at operation S6. The search information which is searched according to the search speed is sequentially displayed on the display part 30 at operation S7.

In an exemplary embodiment of the present invention, the TV is provided as the electronic apparatus and the increase/ decrease period is 10 items/sec. Also, in another embodiment of the present invention, the broadcast channel No. 2 is displayed on the display part 30 when the consecutive search function is selected. If the consecutive search function is selected through the user selection part 70, the broadcast channel is sequentially converted and displayed, and converted at a slower speed than the preset reference speed in broadcast channels such as No. 12, 22 etc. Thus, a user recognizes which channel is displayed on the display part 30 without difficulty, thereby stopping searching the broadcast channel at a broadcast channel that is close to the desired channel at operation S8. If the search is stopped, the display part 30 displays the search information searched when stopping the search at operation S9.

If the display part 30 displays a plurality of lists of the search information, the searched search information may be distinguished from other search information. Meanwhile, if displaying the searched search information only, the display part 30 may sequentially display the search information searched according to the search speed.

As described above, the electronic apparatus according to the present invention may reduce time to search the search information thanks to the high search speed. Further, a user may recognize the progress of the search without difficulty and stop searching at a point where the desired search information is close, as the search speed is low by each predetermined period. Thus, a user may receive the desired search information quickly and easily.

While a few exemplary embodiments of the present invention have been shown and described, it will be appreciated by those skilled in the art that changes may be made in these exemplary embodiments without departing from the scope of the invention defined in the appended claims.

## Claims

1. An electronic apparatus comprising:
means (40) for storing a plurality of search items;
a display (30);
a controller (50) configured to search the search items consecutively, to display the search items consecutively on the display (30), and to control a search speed, being a speed at which the search items are displayed during a search session, wherein the controller (50) is arranged to vary the search speed between a relatively high speed and a relatively low speed at which a user can determine the progress of the search; **characterised in that** the controller (50) is configured to vary the search speed periodically between the relatively high speed and the relatively low speed.

2. An apparatus according to claim 1, further comprising a user selection part (70) configured to allow a user to cause the controller (50) to start searching the search items, and to select one of the displayed search items.

3. An apparatus according to claim 2, wherein the user selection part (70) is configured to allow the user to control the search speed.

4. An apparatus according to any one of the preceding claims, wherein the display (30) displays only each consecutively searched item.

5. An apparatus according to any one of claims 1 to 3, wherein the search items are displayed as a list.

6. An apparatus according to claim 5, wherein each consecutively searched item is distinguished from other search items in the list.

7. An apparatus according to claim 4, wherein the electronic apparatus comprises a tuner (25) configured to search a plurality of broadcast channels, and wherein the search items each comprise an image corresponding to a broadcast channel.

8. An apparatus according to any one of the preceding claims, further comprising an interface generator (60) configured to generate an interface picture which is displayed on the display (30), wherein the interface picture comprises a speed adjusting menu.

9. An apparatus according to any one of the preceding claims, wherein the controller (50) increases and decreases the search speed relative to a preset reference speed, which is a speed at which a human can recognise the consecutively displayed search items.

10. A control method of an electronic apparatus having a plurality of search information, comprising:
receiving a selection signal of a consecutive search function;
increasing and decreasing a search speed with respect to the search information between a relatively high speed and a relatively low speed at which a user can determine the progress of the search if the selection signal of the consecutive search function is received; and
displaying a selected search information; **characterised in that** the increasing and decreasing of the search speed is carried out periodically.

11. The control method according to claim 10, wherein the displaying the selected search information comprises displaying a list of the search information, and displaying a searched search information to be distinguished from other search information.

12. The control method according to claim 10, wherein the displaying a searched search information comprises displaying the searched search information only.

13. The control method according to claim 12, wherein the searched search information comprises an image corresponding to a TV channel.

14. The control method according to claim 11 or 12, further comprising displaying a speed adjusting menu to adjust at least one of a fastest search speed, a slowest search speed and a search speed increase/decrease rate of the search speed.

15. The control method according to any one of claims 10 to 14, further comprising:
displaying a period adjusting menu to adjust a search period of the search speed.

## Patentansprüche

1. Elektronische Vorrichtung, umfassend:
Mittel (40) zum Speichern einer Vielzahl von Suchelementen;
eine Anzeige (30);
eine Steuerung (50), die konfiguriert ist, um die Suchelemente aufeinanderfolgend zu suchen, um die Suchelemente aufeinanderfolgend auf der Anzeige (30) anzuzeigen und um eine Suchgeschwindigkeit zu steuern, die eine Geschwindigkeit ist, mit der die Suchelemente während einer Suchsitzung angezeigt werden, wobei die Steuerung (50) angeordnet ist, um die Suchgeschwindigkeit zwischen einer relativ hohen Geschwindigkeit und einer relativ niedrigen Geschwindigkeit, bei der ein Benutzer den Fortschritt der Suche bestimmen kann, zu ändern; **dadurch gekennzeichnet, dass** die Steuerung (50) konfiguriert ist, um die Suchgeschwindigkeit periodisch zwischen der relativ hohen Geschwindigkeit und der relativ niedrigen Geschwindigkeit zu ändern.

2. Vorrichtung nach Anspruch 1, weiter umfassend ein Benutzerauswahlteil (70), das konfiguriert ist, um einem Benutzer zu gestatten, zu bewirken, dass die Steuerung (50) Suchen der Suchelemente startet, und eines der angezeigten Suchelemente auszuwählen.

3. Vorrichtung nach Anspruch 2, wobei das Benutzerauswahlteil (70) konfiguriert ist, um dem Benutzer zu gestatten, die Suchgeschwindigkeit zu steuern.

4. Vorrichtung nach einem der vorstehenden Ansprüche, wobei die Anzeige (30) nur jedes aufeinanderfolgend gesuchte Element anzeigt.

5. Vorrichtung nach einem der Ansprüche 1 bis 3, wobei die Suchelemente als eine Liste angezeigt werden.

6. Vorrichtung nach Anspruch 5, wobei jedes aufeinanderfolgend gesuchte Element von anderen Suchelementen in der Liste unterschieden wird.

7. Vorrichtung nach Anspruch 4, wobei die elektronische Vorrichtung einen Tuner (25) umfasst, der konfiguriert ist, um eine Vielzahl von Rundfunkkanälen zu durchsuchen, und wobei die Suchelemente jeweils ein Bild umfassen, das mit einem Rundfunkkanal korrespondiert.

8. Vorrichtung nach einem der vorstehenden Ansprüche, weiter umfassend einen Schnittstellenerzeuger (60), der konfiguriert ist, um ein Schnittstellenbild zu erzeugen, das auf der Anzeige (30) angezeigt wird, wobei das Schnittstellenbild ein Geschwindigkeitseinstellmenü umfasst.

9. Vorrichtung nach einem der vorstehenden Ansprüche, wobei die Steuerung (50) die Suchgeschwindigkeit relativ zu einer voreingestellten Referenzgeschwindigkeit, die eine Geschwindigkeit ist, bei der ein Mensch die aufeinanderfolgend angezeigten Suchelemente erkennen kann, erhöht und vermindert.

10. Steuerungsverfahren einer elektronischen Vorrichtung mit einer Vielzahl von Suchinformationen, umfassend:
Empfangen eines Auswahlsignals einer aufeinanderfolgenden Suchfunktion:
Erhöhen und Vermindern einer Suchgeschwindigkeit in Bezug auf die Suchinformation zwischen einer relativ hohen Geschwindigkeit und einer relativ niedrigen Geschwindigkeit, bei der ein Benutzer den Fortschritt der Suche bestimmen kann, wenn das Auswahlsignal der aufeinanderfolgenden Suchfunktion empfangen wird; und
Anzeigen einer ausgewählten Suchinformation; **dadurch gekennzeichnet, dass** das Erhöhen und Vermindern der Suchgeschwindigkeit periodisch ausgeführt wird.

11. Steuerungsverfahren nach Anspruch 10, wobei das Anzeigen der ausgewählten Suchinformation umfasst, eine Liste der Suchinformationen anzuzeigen und eine gesuchte Suchinformation, die von anderen Suchinformationen zu unterscheiden ist, anzuzeigen.

12. Steuerungsverfahren nach Anspruch 10, wobei das Anzeigen einer gesuchten Suchinformation umfasst, nur die gesuchte Suchinformation anzuzeigen.

13. Steuerungsverfahren nach Anspruch 12, wobei die gesuchte Suchinformation ein Bild umfasst, das mit einem Fernsehkanal korrespondiert.

14. Steuerungsverfahren nach Anspruch 11 oder 12, weiter umfassend, ein Geschwindigkeitseinstellmenü anzuzeigen, um mindestens eines einer schnellsten Suchgeschwindigkeit, einer langsamsten Suchgeschwindigkeit und einer Suchgeschwindigkeits-Erhöhungs-/Verminderungsrate der Suchgeschwindigkeit einzustellen.

15. Steuerungsverfahren nach einem der Ansprüche 10 bis 14, weiter umfassend:
Anzeigen eines periodischen Einstellmenüs zum Einstellen einer Suchperiode der Suchgeschwindigkeit.

## Revendications

1. Appareil électronique comprenant :
un moyen (40) pour mémoriser une pluralité d'éléments de recherche ;
un affichage (30) ;
une unité de commande (50) configurée pour rechercher les éléments de recherche consécutivement, afficher les éléments de recherche consécutivement sur l'affichage (30), et commander une vitesse de recherche, étant une vitesse à laquelle les éléments de recherche sont affichés durant une session de recherche, dans lequel l'unité de commande (50) est agencée pour faire varier la vitesse de recherche entre une vitesse relativement élevée et une vitesse relativement basse à laquelle un utilisateur peut déterminer le progrès de la recherche ; **caractérisé en ce que** l'unité de commande (50) est configurée pour faire varier la vitesse de recherche périodiquement entre la vitesse relativement élevée et la vitesse relativement basse.

2. Appareil selon la revendication 1, comprenant en outre une partie de sélection d'utilisateur (70) configurée pour permettre à un utilisateur de faire en sorte que l'unité de commande (50) commence à rechercher les éléments de recherche, et de sélectionner l'un des éléments de recherche affichés.

3. Appareil selon la revendication 2, dans lequel la partie de sélection d'utilisateur (70) est configurée pour permettre à l'utilisateur de commander la vitesse de recherche.

4. Appareil selon l'une quelconque des revendications précédentes, dans lequel l'affichage (30) affiche uniquement chaque élément recherché consécutivement.

5. Appareil selon l'une quelconque des revendications 1 à 3, dans lequel les éléments de recherche sont affichés sous forme de liste.

6. Appareil selon la revendication 5, dans lequel chaque élément recherché consécutivement est différencié des autres éléments de recherche dans la liste.

7. Appareil selon la revendication 4, l'appareil électronique comprenant un syntoniseur (25) configuré pour rechercher une pluralité de canaux de diffusion, et
dans lequel les éléments de recherche comprennent chacun une image correspondant à un canal de diffusion.

8. Appareil selon l'une quelconque des revendications précédentes, comprenant en outre un générateur d'interface (60) configuré pour générer une image d'interface qui est affichée sur l'affichage (30), dans lequel l'image d'interface comprend un menu de réglage de vitesse.

9. Appareil selon l'une quelconque des revendications précédentes, dans lequel l'unité de commande (50) augmente et diminue la vitesse de recherche par rapport à une vitesse de référence prédéfinie, laquelle est une vitesse à laquelle une personne peut reconnaître les éléments de recherche affichés consécutivement.

10. Procédé de commande d'un appareil électronique ayant une pluralité d'informations de recherche, comprenant :
la réception d'un signal de sélection d'une fonction de recherche consécutive ;
l'augmentation et la diminution d'une vitesse de recherche relativement aux informations de recherche entre une vitesse relativement élevée et une vitesse relativement basse à laquelle un utilisateur peut déterminer le progrès de la recherche si le signal de sélection de la fonction de recherche consécutive est reçue ; et
l'affichage d'une information de recherche sélectionnée ; **caractérisé en ce que** l'augmentation et la diminution de la vitesse de recherche est effectuée périodiquement.

11. Procédé de commande selon la revendication 10, dans lequel l'affichage de l'information de recherche sélectionnée comprend l'affichage d'une liste des informations de recherche et l'affichage d'une information de recherche recherchée à différencier des autres informations de recherche.

12. Procédé de commande selon la revendication 10, dans lequel l'affichage d'une information de recherche recherchée comprend l'affichage de l'information de recherche recherchée uniquement.

13. Procédé de commande selon la revendication 12, dans lequel l'information de recherche recherchée comprend une image correspondant à un canal de télévision.

14. Procédé de commande selon la revendication 11 ou 12, comprenant en outre l'affichage d'un menu de réglage de vitesse pour régler au moins l'une d'une vitesse de recherche la plus rapide, d'une vitesse de recherche la plus basse et d'un taux d'augmentation/diminution de vitesse de recherche de la vitesse de recherche.

15. Procédé de commande selon l'une quelconque des revendications 10 à 14, comprenant en outre :
l'affichage d'un menu de réglage de période pour régler une période de recherche de la vitesse de recherche.
